# EUROPÄISCHE PATENTSCHRIFT

(11) **EP 3 486 639 B1**
(45) Veröffentlichungstag und Bekanntmachung des Hinweises auf die Patenterteilung: **24.02.2021**
(21) Anmeldenummer: 18207172.0
(22) Anmeldetag: 20.11.2018
(51) Int. Cl.: G01N 21/956, G06T 7/00, H01L 21/67

(54) **VERFAHREN UND VORRICHTUNG ZUR OPTISCHEN DARSTELLUNG VON ELEKTRONISCHEN HALBLEITERBAUELEMENTEN**
METHOD AND DEVICE FOR VISUAL REPRESENTATION OF ELECTRONIC SEMICONDUCTOR DEVICES
PROCÉDÉ ET DISPOSITIF DE REPRÉSENTATION OPTIQUE DES COMPOSANTS ÉLECTRONIQUES À SEMI-CONDUCTEUR

(30) Priorität: 21.11.2017 DE 102017127422
(43) Veröffentlichungstag der Anmeldung: 22.05.2019
(73) Patentinhaber: FormFactor Beaverton, Inc., Beaverton OR 97008 (US)
(72) Erfinder: Fiedler, Jens, 01129 Dresden (DE); Gießmann, Sebastian, 01259 Dresden (DE)
(74) Vertreter: Lippert Stachow Patentanwälte Rechtsanwälte Partnerschaft mbB

(56) Entgegenhaltungen:
- WO-A1-2011/091894
- US-A1- 2004 121 496
- US-A1- 2007 156 379
- US-A1- 2010 111 403

## Beschreibung

Die Erfindung betrifft allgemein ein Verfahren optischen Darstellung von elektronischen Halbleiterbauelementen in einer definierten Relativposition einer Struktureinheit. Sie betrifft ebenso ein Verfahren zur Kontaktierung von elektronischen Halbleiterbauelementen, welches im Rahmen von Prüfverfahren zur Herstellung des physischen und elektrischen Kontakts von Sondenspitzen mit Kontaktinseln zumindest eines der auf der Struktureinheit ausgebildeten Halbleiterbauelements ausgeführt wird und die optische Darstellung verwendet. Die Erfindung betrifft weiterhin Vorrichtungen zur Ausführung dieser Verfahren.

Als Struktureinheit ist hier eine solche Einheit zu verstehen, welche eine Mehrzahl gleicher oder verschiedener Halbleiterbauelemente umfasst. Das sind beispielsweise Wafer mit einer Vielzahl gleicher, im Raster angeordneter Halbleiterbauelemente oder Trägersubstrate oder Schaltungsanordnungen mit mehreren Halbleiterbauelementen und, soweit erforderlich, weiteren Schaltungsstrukturen oder andere Strukturen, die mehrere Halbleiterbauelemente aufweisen.

Solche optischen Darstellungen von Halbleiterbauelementen werden beispielsweise zu deren Prüfung, beispielsweise zu Zwecken der Funktions- oder der Alterungsprüfung, der optischen, Inspektion oder in anderen Verfahrensschritten der Herstellung oder Anwendung der Halbleiterbauelemente genutzt. So verfügen Prüfstationen zur Prüfung und Testung von Halbleiterbauelementen, allgemein als Prober bezeichnet, über geeignete Hard- und Software, welche eine Sicht auf das Halbleiterbauelement bereitstellen, um Strukturen und Kontaktflächen des Halbleiterbauelements zu beobachten und/oder Sondenspitzen und deren Ausrichtung zu den Kontaktflächen.

Prober weisen weiter eine Haltevorrichtung zur Aufnahme und Halterung der Struktureinheit, einen so genannten Chuck auf, welcher eine Oberfläche zur Aufnahme von zu prüfenden Dies hat, hier auch als Haltefläche bezeichnet, und regelmäßig in X- und Y-Richtung des 3-dimensionalen kartesischen Koordinatensystems verfahrbar ist. Der Prober weist weiterhin eine Sondenhalterung für die Sondenspitzen auf, auch Probes genannt, deren Anzahl und Position mit den gleichzeitig mit einem Kontaktierungsvorgang zu kontaktierenden Kontaktflächen des Halbleiterbauelements, auch als Testsubstrat, Die oder DUT (Device under Test) bezeichnet, korrelieren. Auch die Sondenhalterungen können zur Positionierung der Enden der Sondenspitzen relativ zum Halbleiterbauelement in X- und Y-Richtung verfahrbar sein.

Zur Herstellung des physischen und elektrischen Kontaktes ist neben der Verfahrbarkeit von Halbleiterbauelement und/oder Sondenspitzen in der X-Y-Ebene, die häufig als die Ebene definiert ist, in welcher die Haltefläche des Chucks liegt, eine Relativbewegung in Z-Richtung zwischen den Sondenspitzen und dem Halbleiterbauelement erforderlich. Die erforderlichen Zustellbewegungen in Z-Richtung sind meist durch den Chuck im Zusammenhang mit einer Positionierungseinrichtung der Sondenhalterung realisierbar. Werden mehrere Kontaktflächen gleichzeitig durch eine Sondenspitzenandordnung kontaktiert, ist neben der präzisen Ausrichtung von Halbleiterbauelement und Sondenspitzen in X- und Y-Richtung ebenso die präzise winklige Ausrichtung der Anordnung der Sonden zu den Kontaktflächen erforderlich.

Die korrekte X-Y-Relativposition und mitunter auch die korrekte Z-Zustellung zwischen Sondenspitzen und Kontaktflächen werden durch optische Anzeigeeinrichtungen beobachtet.

Zur Prüfung eines Halbleiterbauelements werden dessen Kontaktinseln und die Sondenspitzen in ihren X- und Y-Positionen in Übereinstimmung gebracht, so dass diese sich gegenüber liegen. Von dieser Position aus erfolgt die Zustellbewegung in Z-Richtung zur Herstellung des sicheren physischen und elektrischen Kontakts, so dass mittels geeigneter Prüfeinrichtungen die entsprechenden Prüfsignale eingespeist und/oder abgegriffen werden können. Nach Abschluss der Prüfung eines Halbleiterbauelements kann der Kontakt der Sondenspitzen gelöst werden, so dass die Position eines weiteren Halbleiterbauelements angefahren und dieses zur Prüfung kontaktiert werden kann. Die Position eines Testsubstrats ist relativ zur Geometrie und zum Design der das Testsubstrat aufweisenden Struktureinheit über die Bezugsebenen und Bezugspunkte des Chucks oder geeignete Sensoren bestimmbar.

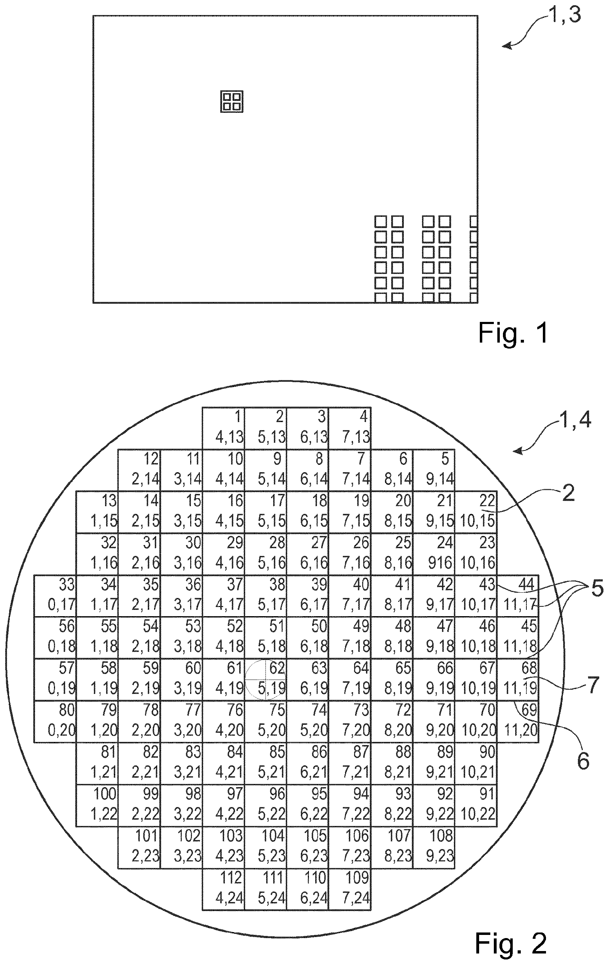

Für die optische Darstellung des Halbleiterbauelements werden in den verschiedenen Anwendungsfällen Mikroskope und/oder Kameras, nachfolgend auch allgemein als Abbildungseinheit bezeichnet, verwendet, welche die zu kontaktierenden Flächen in hoher Auflösung als Livebild (Fig. 1) darstellen und dabei von oben und/oder seitlich auf die Kontaktposition blicken. Die dafür erforderlichen starken Vergrößerungen lassen infolge der hohen Integrationsdichte und damit verknüpft der sehr kleinen darzustellenden Strukturen, die bis in den Mikro- und Nanometerbereich reichen, die eindeutige Identifizierung des vergrößert dargestellten Bereichs und dessen reale Position auf der Struktureinheit allein anhand der sichtbaren Details nicht zu.

Deshalb wird häufig eine ergänzende grafische Darstellung (Fig. 2) der gesamten Struktureinheit (WO 2011/091894 A1) oder eines solchen Ausschnitts davon bereitgestellt, welcher anhand seiner Darstellung eindeutig identifizierbar ist, so dass eine Erfassung der aktuellen Position der Sondenspitzen und eine Navigation auf der Struktureinheit im Verlauf der Positionierungsbewegung möglich ist. In der US 2004/0121496 A1 wird eine ergänzende Darstellung anhand von CAD-Daten erstellt, welche Fehler in der Struktureinheit lokalisieren, was wiederum einen ersten Scan und erste Navigation voraussetzt.

Eine solche grafische Repräsentation enthält verschiedene grafische Merkmale oder Ordnungsmerkmale, die zur Identifizierung und/oder Charakterisierung eines Halbleiterbauelements geeignet sind. Das können beispielsweise die Dimension und die Grenzen jedes einzelnen Halbleiterbauelements, dessen Koordinaten, dessen Teststatus oder andere markante Ordnungsmerkmale sein.

Durch einen Vergleich der realen mit der grafischen Repräsentation kann die Position einer aktuell gezeigten realen Repräsentation in der grafischen Repräsentation ermittelt werden. Im Verlauf des Kontaktierungsverfahrens wird zur Navigation und Prüfung, ob das korrekte Halbleiterbauelement bzw. dessen korrekter Ausschnitt real dargestellt ist, vom Bediener zwischen der realen und der grafischen Repräsentation gewechselt. Der Wechsel zwischen den Darstellungen wird vom Bediener häufig als störend empfunden und kann zudem Ursache für Fehler in der korrekten Positionszuordnung sowie für einen erhöhten Zeitaufwand in der Prüfung sein. Zudem sind die verwendbaren Positionsmarker auf die aus dem Design der Struktureinheit bekannten Marker beschränkt, die sich ebenfalls wiederholen können und deshalb nicht in jedem Fall geeignet sind.

Ausgehend von dem vorbeschriebenen Stand der Technik beschäftigt sich die Erfindung mit der Aufgabe, ein Verfahren zur optischen Darstellung einer Struktureinheiten und der darauf ausgebildeten elektronischen Halbleiterbauelemente, insbesondere für deren Kontaktierungsverfahren, sowie dafür ausgebildete Vorrichtungen bereitstellen, in welchem der Wechsel zwischen verschiedenen Darstellungen vermieden wird.

Weiter sollen geeignete Marker zur Positionsbestimmung auch nach einer Verschiebung der Struktureinheit relativ zur Abbildungseinheit für die Navigation auf der Struktureinheit zur Verfügung stehen.

Weiter sollen auch reale Marker, die vom Bediener als geeignet angesehen werden, für die Positionsbestimmung der realen Darstellung verwendbar sein können.

Die Aufgabenstellung der Erfindung ist verfahrensseitig mit dem Gegenstand des Anspruches 1 gelöst, wobei darauf abgestellt ist, dass für eine Struktureinheit, welche zumindest ein auf deren Vorderseite ausgebildetes Halbleiterbauelement aufweist und auf einer Haltefläche einer Haltevorrichtung angeordnet ist, zumindest eine grafischen Repräsentation, welche elektronisch gespeichert ist, bereitgestellt wird.

Als grafische Repräsentation soll nachfolgend eine Abbildung verstanden sein, welche die Struktureinheit selbst oder ein Ausschnitt davon oder das auf der Struktureinheit ausgebildete und optisch darzustellende Halbleiterbauelement oder ein Ausschnitt davon oder eine Kombination mehrerer der genannten Element betreffen und charakteristische, für die Navigation auf der Struktureinheit geeignete geometrische und/oder strukturelle Marker wiedergeben. Eine grafische Repräsentation kann ergänzend oder alternativ auch weitere für die optische Darstellung, die Navigation und oder ein präzises Zoomen geeignete geometrische Merkmale darstellen. Solche sind z.B. die Grenzen der Haltefläche und/oder geeignete Referenzpunkte der Struktureinheit, des Halbleiterbauelements und/oder der Haltevorrichtung. Die grafische Repräsentation kann ursprünglich auch bis auf ein solches Element oder eine solche Information leer sein, die benötigt wird, um die nachfolgend beschriebene Synchronisation der grafischen Repräsentation mit dem Livebild auszuführen. Das können die Grenzen der Struktureinheit oder eines Halbleiterbauelements oder ein oder mehrere Referenzpunkte oder ähnliches sein. Eine solche "leere" grafische Repräsentation kann durch den Operator mit weiteren Elementen, wie Informationen und grafischen Merkmalen, ergänzt werden, wie nachfolgend näher beschrieben.

Als Vorderseite der Struktureinheit wird hier jene Oberfläche der Struktureinheit bezeichnet, auf der ein zu visualisierendes Halbleiterbauelement ausgebildet ist.

Weiter wird ein Bild des Halbleiterbauelements oder eines Ausschnitts davon mittels einer Abbildungseinheit, welche zu diesem Zweck zumindest einen Bildsensor aufweist, aufgenommen und auf einer ersten Displayeinheit angezeigt. Dieses Bild soll zur Unterscheidung von weiteren damit kombinierten Bildern nachfolgend als Livebild bezeichnet. Es ist anschaulich, dass das Livebild mit einer solchen Auflösung aufgenommen wird und die Displayeinheit geeignet ist, dass eine Darstellung der interessierenden Strukturgrößen, wie beispielsweise Kontaktflächen, Leiterbahnen oder andere Details des Halbleiterbauelements oder der Struktureinheit mit der erforderlichen Auflösung möglich ist.

Weiter wird ebenfalls auf der ersten Displayeinheit, d. h. gemeinsam mit dem Livebild, eine erste grafische Repräsentation aus den oben beschriebenen Varianten derart angezeigt, dass Elemente der ersten grafischen Repräsentation das Livebild überlagern. Die Überlagerung erfolgt derart, dass wesentliche Bildinhalte beider Darstellungen gleichzeitig sichtbar sind. Zu diesem Zweck werden rechentechnisch jene Bildinhalte ausgeblendet werden, die nicht benötigt werden und die Darstellung stören. Eine solche partielle Darstellung des Livebildes oder der grafischen Darstellung kann beispielsweise derart erfolgen, dass deren Inhalte verschiedenen Layern zugeordnet werden, die einzeln ausgewählt, bearbeitet und angezeigt werden können. Beispielsweise auf Fig. 2 bezogen wäre es sinnvoll, die als durchgehende Linien sichtbaren Grenzen der einzelnen Halbleiterbauelement des Wafers einem ersten Layer, die Bezeichnungen der Halbleiterbauelemente einem zweiten Layer und den Wafer mit seiner Grenze und die Haltefläche einem dritten Layer zuzuordnen. Zu Überlagerung des Livebildes könnten der erste und der zweite Layer verwendet werden, so dass deren Inhalte als überlagernde Elemente vor dem Hintergrund eines Livebildes dargestellt werden. Ein überlagerndes Element einer grafischen Repräsentation wird nachfolgend als Overlay bezeichnet.

Als Overlay verwendbare Elemente der grafischen Repräsentation können all jene Bestandteile der grafischen Repräsentation sein, die zur Navigation und Orientierung auf der Struktureinheit und Identifizierung und/oder Charakterisierung eines Halbleiterbauelements sowie deren Bestandteile geeignet sind. Der Fachmann kennt zahlreiche dafür geeignete Elemente der grafischen Repräsentationen und ist in der Lage weitere als geeignet zu identifizieren. So können Grenzen, Koordinaten und Testinformationen der Halbleiterbauelemente, Details der Halbleiterbauelemente und deren Definition bzw. Kennzeichnung, Grenzlinien, die bei Bewegungen der Struktureinheit nicht überschritten werden sollen sowie weitere geeignete positionsbezogene Informationen genutzt werden. Diese können auf einem oder mehreren Layern einer grafischen Repräsentation funktionell sinnvoll angeordnet und damit gezielt zur Anzeige gebracht oder ausgeblendet werden.

Ist ein Detail der Struktureinheit von besonderem Interesse, kann mit der Aufnahmeeinheit ein Schnappschuss erzeugt werden, der sowohl das Livedetail als auch dazugehörige Overlays abbildet.

Um mittels der Overlays die korrespondierenden realen Details (Element) des Livebildes zu identifizieren, erfolgt in einem weiteren Verfahrensschritt eine computergestützte Synchronisierung der ersten grafischen Repräsentation mit dem Livebild. Die Synchronisierung erfolgt beispielsweise mittels Positionsbezügen der Haltevorrichtung und/oder der Struktureinheit, wie Koordinaten einer Bezugsebene oder Bezugspunkte, die auf die Abbildungseinheit und damit auch auf das Livebild übertragbar sind. Diese finden Entsprechungen in der grafischen Repräsentation oder lassen einen eindeutigen Bezug darauf herstellen, so dass darüber eine eindeutige lokale und winklige Zuordnung zwischen beiden Darstellungen zu erzeugen ist.

Die Auswahl von Positionen, die zur Synchronisierung geeignet sind, und die Synchronisierung selbst kann computergestützt oder visuell oder mittels Kombination von beidem erfolgen. Bei einer visuellen Synchronisierung werden eine klar zu identifizierende Struktur, welche sowohl real als auch als Overlay vorhanden ist, unter Beobachtung zueinander positioniert und beide Positionen als übereinstimmend vermerkt. Beispielsweise kann der Nutzer eine Ecke eines Halbleiterbauelements genau unter die Mitte des Bildes der beobachtenden Kamera fahren. Dieser Eckpunkt ist sowohl im Livebild als auch in der grafischen Repräsentation eindeutig auffindbar.

Das computergestützte Ermitteln, Zuordnen und Verknüpfen der Positionsbezüge und ihren Entsprechungen kann mittels eines softwareseitig entsprechend konditionierten Computers erfolgen, welcher zur Steuerung der Haltevorrichtung und der Abbildungseinheit dient und in welchem die grafischen Repräsentationen gespeichert sind. Über die Computersteuerung besteht ein Zugriff auf die Positionen der Haltevorrichtung und/oder der Struktureinheit, deren Bezugsebenen oder Bezugspunkte sowie deren aktuelle und anzufahrende Koordinaten.

Das wesentliche Konzept der Erfindung ist auch dahingehend zu beschreiben, dass die grafischen Repräsentationen mit der Sicht der Abbildungseinheit auf die Struktureinheit und mit der Position der Haltefläche korrekt verknüpft sind, so dass die adaptierbare grafische Repräsentation Bestandteil der realen Darstellung wird. Damit ist es möglich, dass bei einer Änderung des Zooms und des dargestellten Ausschnitts an der Livedarstellung sofort das sichtbare Detail identifizierbar ist. Eine solche, lokal identifizierbare und zusätzliche Informationen enthaltende optische Darstellung von selbst stark vergrößerten Auszügen einer Struktureinheit wird in vielen Bereichen der Mikroelektronik benötigt, wo die zunehmende Skalierung immer höhere Anforderungen an die optische Darstellung stellt.

Die Verknüpfung, d. h. Synchronisation der grafischen Repräsentation mit dem Livebild kann in einer Ausgestaltung des Verfahrens derart erfolgen, dass solch eine synchronisierte grafische Repräsentation einer Verschiebung der Struktureinheit relativ zur Abbildungseinheit folgt. Eine solche Relativverschiebung resultiert in einer Änderung des im Livebild dargestellten Ausschnitts der Struktureinheit oder in einer Änderung der Lage der Struktureinheit im Livebild. Im Ergebnis einer solchen Synchronisation widerspiegelt sich jede durch die Relativbewegung verursachte Änderung des Livebildes unmittelbar in der entsprechenden Änderung der angezeigten grafischen Repräsentation, so dass in dem sichtbaren Ausschnitt der Struktureinheit die grafische Repräsentation nach der Relativbewegung mit dem Livebild korrespondiert und in jeder neuen Darstellung die Overlays aktualisiert sind, so dass dann die Overlays dargestellt sind, die zum sichtbaren Ausschnitt der Struktureinheit gehören.

Da das hier beschriebene Verfahren insbesondere für die Navigation bzw. Orientierung auf einem stark vergrößert dargestellten Ausschnitt der Struktureinheit geeignet ist, soll es nachfolgend anhand dieser Anwendung beschrieben werden. In analoger Weise kann das Verfahren auch auf eine vollständige Darstellung einer Struktureinheit angewendet werden.

Die Relativbewegung zwischen Struktureinheit und Abbildungseinheit wird regelmäßig mittels geeigneter Positionierungsvorrichtungen ausgeführt, die entweder die Haltefläche oder die Abbildungseinheit oder beide entlang von Verfahrwegen bewegen, die anhand der oben angeführten Positionsbezüge oder anhand der Steuerung der Bewegungsvorrichtungen präzise, meist auch automatisiert abfahrbar sind. Diesen Verfahrwegen kann die gespeicherte grafische Repräsentation mittels einer Computersteuereinheit virtuell nachgeführt werden. Alternativ oder ergänzend kann der Bewegungsverlauf oder der neue Bildausschnitt des Livebildes rechentechnisch aus dem Livebild selbst ermittelt und die grafische Repräsentation diesem angepasst werden.

Auch andere durch die verwendete Vorrichtung unterstützte Möglichkeiten, die grafische Repräsentation dem Livebild nachzuführen können genutzt werden.

Die optische Darstellung von Halbleiterbauelementen kann zu verschiedenen Zwecken erfolgen, z. B. zur optischen Prüfung der Struktureinheit, zur Positionierung von Kontaktsonden auf ausgewählten Kontaktflächen des Halbleiterbauelements oder zu anderen Zwecken. Für den Fall der Positionierung von Kontaktsonden, die bei den hier betrachteten Größenordnungen sehr kleine Sondenspitzen aufweisen, kann das Livebild neben dem Halbleiterbauelement zumindest eine der Sondenspitzen darstellen, wenn die Sondenspitzen zumindest grob zu den Kontaktflächen ausgerichtet sind. Alternativ oder ergänzend kann auch eine grafische Repräsentation die Sondenspitzen oder als solche identifizierbare Zeichen als Overlays darstellen. Auch zu den Sondenspitzen können in ihrer grafischen Repräsentation zusätzliche Informationen dargestellt werden, wie eine Nummerierung, eine Positionskennzeichnung, ein vom Operator generiertes oder anderes Overlay, wobei die oben beschriebenen Variationen zu deren Anordnung auf grafischen Repräsentationen und deren Layern auch hier anwendbar sind.

Häufig erkennt ein Operator, der eine optische Darstellung eines Ausschnitts einer Struktureinheit vornimmt, besondere Eigenheiten auf der Struktureinheit, die grundsätzlich zur Orientierung verwendbar wären. Das können Fehler oder Abweichungen in der Struktureinheit und/oder den Halbleiterbauelementen, Grenzen von Bauelementen, Referenzmarken oder andere lokal differenzierbare Kennzeichen sein. Um diese für Navigation und Orientierung nutzen zu können, ergänzt der Operator in einer weiteren Ausgestaltung des Verfahrens ein oder mehrere Overlays in einer oder mehreren geeigneten der für die Struktureinheit gespeicherten grafischen Repräsentation. Durch die Ergänzung der anwendungsspezifisch generierten Overlays in einer grafischen Repräsentation, optional auf separaten Layern, sind auch diese Overlays mit dem Livebild synchronisiert und können wieder aufgefunden werden.

Derartige Overlays können grafische Markierungen sein, wie Kreise, Fadenkreuze, Rechtecke, Linien oder andere. Sie können auch Text enthalten zur Beschreibung der markierten Eigenheit der Struktureinheit. Auch farbliche Unterschiede der Overlays zu deren Ordnung oder alleinige farbliche Markierungen von Details des Livebildes sind möglich. Die Generierung solcher anwendungsspezifischer Overlay erfolgt mittels einer geeigneten Eingabevorrichtung, wie einer Tastatur, Maus, auf Touchscreens oder grafischen Tablets anwendbaren Eingabestiften oder anderen derartigen Vorrichtungen.

Umfasst die Struktureinheit eine Mehrzahl sich wiederholender Details, wie eine Vielzahl gleicher Halbleiterbauelemente eines Wafers, können ein oder mehrere Overlays, die einem solchen Detail zugeordnet und in einem Ausschnitt der Struktureinheit dargestellt werden, in einem Overlaybild festgehalten und das Overlaybild als eine weitere grafische Repräsentation für weitere gleichartige Ausschnitt der Struktureinheit verwendet werden. Bei der optischen Darstellung von Halbleiterbauelementen auf Waferlevel können so mehrere Halbleiterbauelemente oder Ausschnitte davon, wie z.B. einzelne Kontaktflächen, nacheinander dargestellt und eine der dem ersten Halbleiterbauelement zugeordneten grafischen Repräsentationen für zumindest ein weiteres der Halbleiterbauelemente verwendet werden.

Derartige Overlaybilder reduzieren den Aufwand zur Generierung der für eine Struktureinheit benötigten grafischen Repräsentationen und den Umfang an grafischen Repräsentationen. Weiter sind zur Orientierung innerhalb eines interessierenden Details oder mehreren gleichartigen davon dienlich bei entsprechend hoher Vergrößerung des Livebildes.

Für die Navigation auf der Struktureinheit kann es entsprechend einer weiteren Ausgestaltung des Verfahrens hilfreich sein, wenn zumindest eine der weiteren grafischen Repräsentationen auf der ersten Displayeinheit oder einer zweiten Displayeinheit angezeigt wird. Ob eine der weiteren grafischen Repräsentation, die neben den standardisiert zur Struktureinheit bereitstehenden Informationen weitere, durch den Operator hinzugefügte oder externe Komponenten charakterisierende, Informationen auf der ersten oder einer weiteren Displayeinheit angezeigt werden, hängt vom Informationsgehalt der weiteren grafischen Repräsentation ab. Die Darstellung auf ein und derselben Displayeinheit kommt z. B. in Betracht, wenn die weitere grafische Repräsentation ergänzende Informationen zu den einzelnen Bauelementen zeigt und damit die optische Darstellung bereichert. Die Darstellung auf separaten Displayeinheiten ist dann sinnvoll, wenn mit beiden Displayeinheiten verschiedene Aufgabenstellungen realisiert werden sollen, z.B. eine vergrößerte Darstellung auf der ersten und eine Darstellung der vollständigen oder eines größeren Abschnitts der Struktureinheit auf der zweiten Displayeinheit.

Eine Anwendung des zuvor beschriebenen Verfahrens zur optischen Darstellung sind Verfahren zur Kontaktierung eines auf der Vorderseite einer Struktureinheit ausgebildeten Halbleiterbauelements mittels Sondenspitzen, wobei letzteres sowohl dem Auffinden der zu kontaktierenden Kontaktflächen wie zuvor beschrieben als auch der Positionierung der Sondenspitzen relativ zu den Kontaktfläche und Herstellung des physischen und elektrischen Kontakts dienen kann. Für die Positionierung und Herstellung des Kontakts ist augenscheinlich die Darstellung zumindest einer Sondenspitze im Livebild und/oder in einer grafischen Repräsentation erforderlich.

Das Kontaktierungsverfahren umfasst folgende grundlegende Verfahrensschritte:
Zunächst erfolgt die optische Darstellung eines Halbleiterbauelements einer Struktureinheit, welches kontaktiert werden soll, oder eines Ausschnitts davon, unter Verwendung des zuvor beschriebenen Verfahrens, wobei zumindest jene Kontaktflächen von der Anzeige mit erfasst sein sollten, auf welchen die Kontaktspitzen platziert werden sollen.

Zeitgleich oder anschließend werden die Sondenspitzen im Livebild oder einer weiteren grafischen Repräsentation gemäß obiger Beschreibung in die optische Darstellung aufgenommen, so dass dann anhand der Darstellung der Sondenspitzen die Ausrichtung der Position der Kontaktflächen des Halbleiterbauelements und der Sondenspitzen relativ zueinander erfolgen kann. Das erfolgt derart, dass unter Beobachtung mittels des Verfahrens zur optischen Darstellung die erforderlichen Bewegungen von Sondenspitzen und/oder Kontaktflächen relativ zueinander ausgeführt werden bis sich Kontaktflächen und Sondenspitzen mit einem Abstand gegenüber liegen. Dann kann die finale Zustellbewegung zwischen Halbleiterbauelement und Sondenspitzen bis zur Herstellung eines physischen und elektrischen Kontakts erfolgen. Bekannte Verfahrensschritte würde der Fachmann ergänzen, soweit es sinnvoll oder notwendig ist.

Mit dem Kontaktierungsverfahren können das zu kontaktierende Halbleiterbauelement und/oder einzelne Kontaktflächen gemeinsam mit den Sondenspitzen oder grafischer Zeichen davon in einer Anzeige dargestellt werden. Diese Darstellung kann durch grafische Repräsentationen mit deren Overlays zur Vervollständigung der Informationen über das zu kontaktierende Halbleiterbauelement und gegebenenfalls auch der Sondenspitzen ergänzt werden. Dies ist insbesondere von Interesse, wenn von einer Vielzahl von Kontaktflächen nur wenige angezeigt werden.

Eine geeignete grafische Repräsentation ist beispielsweise ein Wafermap (Fig. 2). Dieser zeigt als Elemente der grafischen Repräsentation üblicherweise das Muster der auf dem Wafer angeordneten Halbleiterbauelemente und beziffert deren Positionen nach einer vordefinierten Regel. Weiter sind die X-Y-Koordinaten jedes Halbleiterbauelements, dessen Nummer, Größe, Grenzen, und Orientierung entnehmbar sowie Form und Größe der Struktureinheit. Für die Zwecke der Prüfung können außerdem das aktuell im Test befindliche Halbleiterbauelement, das erste zu testende Halbleiterbauelement sowie das Referenzbauelement gekennzeichnet werden.

Über diese grundlegenden Informationen hinaus können zudem für die Orientierung sowie für die Tests der Struktureinheit die Klassifizierung der Halbleiterbauelemente nach den Ergebnissen vorheriger Messungen (Binning-Informationen) von Interesse sein sowie Anzahl, Position, Größe und Binning Information von Unterstrukturen des Halbleiterbauelements und andere.Informationen zur Struktureineheit, so dass auch diese in eine grafische Repräsentation aufgenommen werden können.

Ist die gewünschte grafische Repräsentation konfiguriert, kann sie in der Darstellung des Livebildes der Struktureinheit korrespondierend angezeigt werden, so dass das Halbleiterbauelement XY winklig und in der Fläche exakt mit dem realen Halbleiterbauelement übereinstimmt. Die so erzeugte Darstellung zeigt neben dem Livebild alle Informationen des Wafermaps, wie Koordinaten und Bauelementgrenzen. Ergänzend kann der Operator anwenderspezifische Oerlays eingeben.

Jedes Overlay, das aus dem Wafermap und/oder aus gegebenenfalls anderen grafischen Repräsentationen und/oder aus der weiteren grafischen Repräsentation mit anwendungsspezifisch generierten Overlays zur Verfügung steht, ist infolge der Synchronisation von Livebild und grafischer Repräsentation mit einer Position der Haltefläche, und damit der darauf angeordneten Struktureinheit, verknüpft, so dass bei einer Bewegung der Haltefläche die Overlays fortlaufend entsprechend der Positionsänderungen neu ermittelt und auf der geänderten Darstellung angezeigt werden können. Dies erfolgt rechentechnisch unter Nutzung der jeweils aktuellen Positionsinformationen der Haltevorrichtung. Da sich eine Livebildänderung in gleicher Weise auch durch eine Bewegung der Abbildungseinheit ergeben würde, sofern diese beweglich ausgebildeten ist, werden in diesem Fall die Positionsinformationen und die Positionsänderungen in analoger Weise alternativ oder ergänzend auch von der Bewegungseinrichtung der Abbildungseinheit zum Nachführen der grafischen Repräsentation verwendet.

Vorrichtungsseitig ist die Aufgabenstellung der Erfindung mit dem Gegenstand des Anspruchs 7 gelöst, wobei darauf abgestellt ist, dass die Vorrichtung grob gesprochen folgende grundlegende Komponenten umfasst:
- eine Haltevorrichtung mit einer Haltefläche zur Aufnahme einer Struktureinheit,
- eine Abbildungseinheit zur Beobachtung und Aufnahme von Livebildern eines Halbleiterbauelements,
- eine Bewegungsvorrichtung, welche die Haltevorrichtung und/oder die Abbildungseinheit relativ zueinander in zumindest einer Ebene, welche parallel zur Haltefläche liegt, bewegt,
- eine Speichereinheit zur Speicherung von Livebildern und grafischen Repräsentationen,
- zumindest eine Displayeinheit zur Darstellung der Livebilder und/oder grafischen Repräsentationen und
- eine Computersteuereinheit, die ausgebildet ist zur Steuerung der Abbildungseinheit, der Bewegungsvorrichtung, der Speichereinheit und der Displayeinheit.

Die Software der Computersteuereinheit ist derart ausgebildet, dass sie auf der Basis der Positionsinformationen der Haltevorrichtung zur Haltefläche und der Abbildungseinheit und daraus folgend zur Abbildung eine rechentechnische Synchronisation zumindest einer gespeicherten grafischen Repräsentation mit einem Livebild ausführen kann, so dass ein Element der grafischen Repräsentation mit einem Element des Livebildes korrespondiert.

Eine derartige, korrespondierende Abbildung kann infolge der Synchronisation und unter Verwendung aktueller Positionsinformationen, die aus der Steuerung der Bewegungsvorrichtung gewonnen werden kann, gemäß obiger Beschreibung des mit der Vorrichtung ausführbaren Verfahrens, fortlaufend aktualisiert werden.

Die Speichereinheit der Computersteuereinheit kann auch der Speicherung der Bilder, der grafischen Repräsentationen und Overlays dienen. Alternativ können diese auch in einer externen Speichereinheit, z.B. eines Netzwerks gespeichert werden.

Eine geeignete Computersteuereinheit umfasst regelmäßig auch die weiteren erforderliche Bedienelemente, wie Tastatur, Maus, grafische Eingabehilfen etc. die zur Bedienung der Steuereinheit und ebenso zur Eingabe und Erzeugung von Informationen dienen, welche für die Generierung anwenderspezifischer Overlays verwendbar sind. Diese Informationen können Elemente der Struktureinheit, des Halbleiterbauelements, des Livebildes oder einer grafische Repräsentation sein. Auch Informationen, die aus sinnvollen Kombinationen dieser Elemente gewonnen werden, können zur Erzeugung von Overlays genutzt werden.

Sofern die obige Vorrichtung zur Kontaktierung der Halbleiterbauelemente der Struktureinheit konfiguriert ist, weist diese zusätzlich Sondenspitzen zur physischen und elektrischen Kontaktierung des Halbleiterbauelements auf. Zudem ist die Bewegungsvorrichtung derart ausgebildet, dass die Sondenspitzen und/oder die Haltefläche relativ zueinander zur Herstellung des Kontakts zustellbar sind, wobei die Zustellung die notwendigen Positionierungsschritte umfasst. Demzufolge können die Sondenspitzen und/oder die Haltevorrichtung, wie allgemein von Probern bekannt in X-, Y- und/oder Z-Richtung bewegbar und/oder im Winkel zueinander ausrichtbar sein.

Die Erfindung soll nachfolgend anhand vom Ausführungsbeispielen beispielhaft, jedoch nicht beschränkend, näher erläutert werden. Der Fachmann würde die zuvor und nachfolgend in den verschiedenen Ausgestaltungen der Erfindung realisierten Merkmale in weiteren Ausführungsformen zweckmäßig kombinieren und analog auch für andere Anwendungen verwenden, soweit es die jeweiligen Anforderungen für das Verfahren erfordern und gestatten.

Die zu den Ausführungsbeispielen gehörigen Zeichnungen zeigen in
- Fig. 1: ein Livebild eine Ausschnitts eines Wafers;
- Fig. 2: ein Wafermap;
- Fig. 3: den Waferausschnitt der Fig. 1 überlagert mit einer grafischen Repräsentation;

- Fig. 4: einen Waferausschnitt als Livebild, überlagert mit einer weiteren grafischen Repräsentation und
- Fig. 5: einen Prober, mit welchem die erfindungsgemäßen Verfahren ausführbar sind.

Fig. 1 zeigt einen realen Ausschnitts einer Struktureinheit 1, vorliegend eines Wafers 1 als Livebild 3. Zu sehen sind Strukturen, deren Zugehörigkeit aus der Abbildung nicht zu entnehmen ist.

Fig. 2 zeigt ein Wafermap als grafische Repräsentation 4 eines Wafers 1. Erkennbar sind die einzelnen, quadratischen und optional gleichartigen Halbleiterbauelemente 2, deren Halbleiterbauelement-Kennzeichnung 7 die Nummer des Halbleiterbauelements und dessen Position in der Reihe und Spalte enthält. Anhand dieser Informationen ist jedes Halbleiterbauelement 2 eindeutig zu identifizieren und infolge der Kenntnis der Größe der Halbleiterbauelemente 2 die Position zu ermitteln. Das Wafermap ist, wie auch alle weiteren, nachfolgend beschriebenen Abbildungen, grafischen Repräsentation 4 und Overlays 5 in der Speichereinheit (nicht dargestellt) gespeichert.

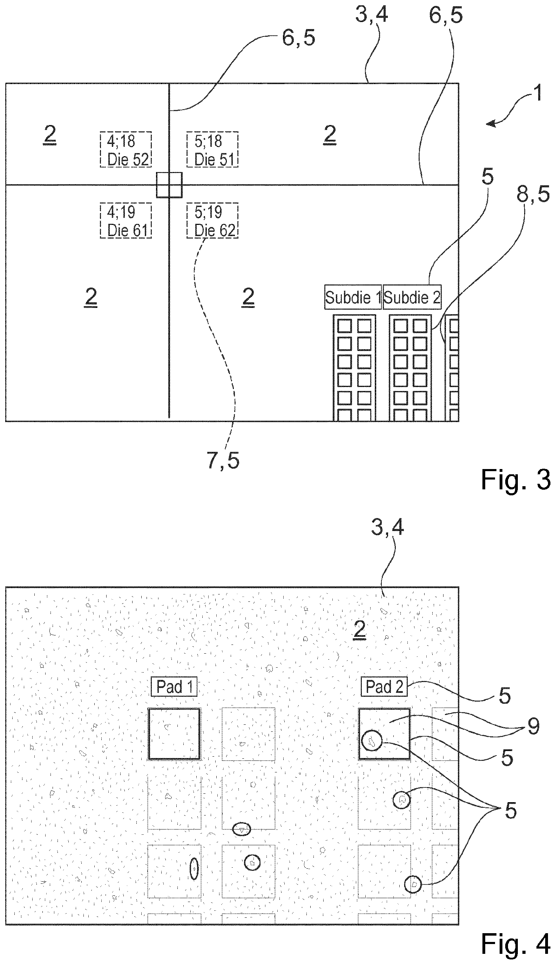

Fig. 3 zeigt den Waferausschnitt gemäß Fig. 1, dessen Livebild 3 mit einer grafischen Repräsentation 4 überlagert ist. Die grafische Repräsentation 4 ist durch mehrere Overlays 5 gebildet. Vorliegend sind das die Halbleiterbauelement-Grenzen 6, die Halbleiterbauelement-Kennzeichnungen 7 sowie die Bezeichnungen und Grenzen der Kontaktflächenreihen 8. Anhand dieser Informationen ist das Halbleiterbauelement 2, dessen Kontaktflächen-Reihen 8 abgebildet sind eindeutig als Halbleiterbauelement ("Die") Nr. 62 zu identifizieren. Auf Fig. 2, deren Abbildung optional gleichzeitig in Form von Bild-im-Bild mit der Abbildung der Fig. 3 auf einem Display (nicht dargestellt) gezeigt werden kann, ist die Lage des betreffenden Halbleiterbauelements 2 ersichtlich. Die in Fig. 3 gezeigten Overlays 5, die das Halbleiterbauelement 2 betreffen, sind Teil des Wafermaps. Die Overlays 5, die die Kontaktflächen-Reihen 8 kennzeichnen, sind einer grafischen Repräsentation entnommen, welche die Elemente des Halbleiterbauelements 2 kennzeichnen und auch auf die anderen, gleichartigen Halbleiterbauelemente 2 des Wafers 1 angewendet werden können. Das kann durch die Zugehörigkeit dieser Overlays 5 zu einer eigenen grafischen Repräsentation 4 oder zu einem Layer (nicht dargestellt) der grafischen Repräsentation 4 des Wafermaps realisiert sein.

Fig. 4 zeigt eine vergrößerte Darstellung der Kontaktflächen-Reihen 8 aus Fig. 3. Auch deren Livebild 3 weist Overlays 5 einer weiteren grafischen Repräsentation 4 auf. Diese Overlays 5 markieren Nummer und Größe der Kontaktflächen ("Pad") 1 und 2 und sind ebenfalls auf gleichartige Halbleiterbauelemente 2 des Wafers 1 anwendbar.

Weiter sind hier besondere Strukturmerkmale der Kontaktflächen 9 durch elliptische Overlays 5 gekennzeichnet, so dass anhand dieser gespeicherten Overlays 5 auch die Kontaktflächen 9 eindeutig einem Halbleiterbauelement 2 zuzuordnen und identifizierbar sind.

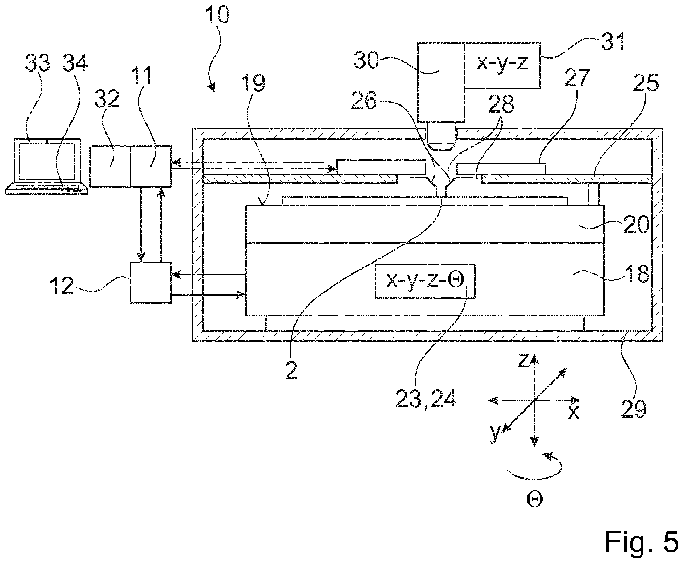

Fig. 5 stellt schematisch und ohne Anspruch auf Vollständigkeit einen Prober 10 dar, welcher zur Ausführung des erfinderischen Verfahrens ausgebildet ist.

Der Prober 10 umfasst eine Haltevorrichtung 18, auch als Chuck bezeichnet, mit einer Haltefläche 19 zur Aufnahme von Struktureinheiten 21. Die Haltefläche 19 ist im dargestellten Ausführungsbeispiel die obere Fläche einer Auflageplatte 20, die dem Chuck 18 entnehmbar ist.

Der Prober 10 umfasst weiter eine Sondenhalterung 25, die der Haltefläche 19 gegenüberliegend angeordnet ist. Die Sondenhalterung 25 hält eine Mehrzahl von Sondenspitzen 26, die zueinander derart angeordnet sind, dass sie mit der Anordnung der gleichzeitig zu kontaktierenden Kontaktflächen (nicht näher dargestellt) des Halbleiterbauelements 2 der Struktureinheit 21 korrespondieren. Die Sondenspitzen 26 werden in ihrer definierten Lage zueinander allgemein als Sondenanordnung 26 bezeichnet. Im dargestellten Ausführungsbeispiel ist die Sondenanordnung 26 an einer so genannten Probecard 27 fest montiert.

Eine Probecard 27 ist üblicherweise eine Leiterplatte, auf der die nadelförmigen Sondenspitzen 26 präzise ausgerichtet und fixiert sind und auf der auch die Zuleitungen zu den einzelnen Sondenspitzen 26 als Leiterbahnen ausgebildet sind. Alternativ können auch separate Sondenspitzen 26 auf der Sondenhalterung 25 montiert sein. Häufig sind separate Sondenspitzen 26 auch mittels geeigneter Manipulatoren (nicht dargestellt) direkt auf der Sondenhalterung 25 zueinander ausrichtbar. Derartige separate Sondenspitzen 26 werden meist für Einzelmessungen verwendet, für die die Herstellung einer Probecard 27 zu aufwändig ist.

Um die Struktureinheit 21 und die Sondenanordnung 26 relativ zueinander zu bewegen und zu positionieren, umfasst der Prober 10 weiter eine Bewegungseinheit 23. Diese kann sehr unterschiedlich aufgebaut sein, in Abhängigkeit davon, welche Komponenten bewegt werden sollen. Üblicherweise umfasst eine Bewegungseinheit 23 einen Antrieb 24 für den Chuck 18, so dass dieser in X-, Y- und meist auch Z-Richtung verfahrbar ist. Für eine Winkelausrichtung ist der Chuck 18 regelmäßig um einen Winkel Θ drehbar. Die Lage von X-, Y-, und Z-Richtung sowie dem Winkel Θ ist dem Piktogramm in Fig. 5 zu entnehmen und entspricht der üblichen Ausrichtung. Der Antrieb 24 des Chucks 18 kann handbetrieben oder motorisiert sein, für automatisierte Bewegungsabläufe ist ein motorisierter Antrieb 24 angeordnet, der durch eine Maschinensteuerung 12 gesteuert wird, welche die Steuersignale in Leistungssignale wandelt. Alternativ kann die Maschinensteuerung 12 auch Teil der Prozesssteuerung 3 sein.

Zur Herstellung des elektrischen Kontakts der Sondenanordnung 26 auf dem Struktureinheit 21 ist neben der Verfahrbarkeit des Struktureinheits 21 in der X-Y-Ebene, die meist als die Ebene definiert ist, in welcher die Haltefläche 19 des Chucks 18 liegt, eine Relativbewegung in Z-Richtung zwischen der Sondenanordnung 26 und dem Struktureinheit 21 erforderlich. Die erforderlichen Bewegungen in Z-Richtung werden im Ausführungsbeispiel mit einer Probecard 27 allein durch den Chuck 18 ausgeführt. Alternativ ist auch eine Kombination der Chuckbewegung mit einer Bewegung der Sondenanordnung 26 in Z-Richtung für die finale Sondenzustellung möglich. In diesem Fall weisen auch die Sonden manuelle oder motorisiert betriebene Manipulatoren, auf, z.B. Kreuztische, die mit Mikrometerschrauben angetrieben werden. Alle genannten Komponenten für die Bewegung von Struktureinheit 21 und Sonden 26 relativ zueinander zum Zweck der Positionierung und Kontaktierung werden der Bewegungseinheit 23 zugeordnet.

Zur Beobachtung der Bewegung und der Positionierung und gegebenenfalls auch der Kontaktierung weist der Prober 10 eine Abbildungseinheit 30 auf, die mittels einer eigenen, mit der zentralen Computersteuereinheit 11 kommunizierenden Steuerung 31 in X-, Y- und Z-Richtung verfahrbar ist, um den gewünschten Abschnitt der Struktureinheit 1, z.B. den Kontaktierungsbereich. in der erforderlichen Auflösung sichtbar zu machen. Alternativ kann die Abbildungseinheit 30 auch mittels der Computersteuereinheit 11 bewegt werden. Die Beobachtung des Struktureinheit 1 erfolgt durch korrespondierende zentrale Öffnungen 28 in der Sondenhalterung 25 und in der Probecard 27 sowie auch im Gehäuse 29, das die beschriebenen Komponenten umgibt.

Die zentrale Computersteuereinheit 11 des Probers realisiert mittels geeigneter Hardware und Software insbesondere auch die optische Darstellung eines gewünschten Ausschnitts der Struktureinheit 1 im Livebild 3 sowie einer gespeicherten grafischen Repräsentation oder mehrerer davon sowie deren Synchronisation wie oben beschrieben. Mittels der Computersteuereinheit 11 können zudem jene Abläufe der oben beschriebenen Verfahren zur optischen Darstellung und zur Kontaktierung von Halbleiterbauelementen 2 gesteuert werden, welche die Bewegung der Auflagefläche 19 und/oder der Abbildungseinheit 30, dem Betrieb der Abbildungseinheit 30 und der Displayeinheit 33 sowie gegebenenfalls den Betrieb der Sondenanordnung 26, auch deren Signalübertragung und Signalverarbeitung, betreffen. Mittels der Computersteuereinheit 11 kann auch die Steuerung des mit dem Prober 10 auszuführenden Prüfablaufs realisiert werden.

In einer Speichereinheit 32, welche regelmäßig der Computersteuereinheit 11 zugeordnet ist, sind alle für die Navigation auf der Struktureinheit 1 und optische Darstellung deren Halbleiterbauelemente 2 gemäß oben beschriebenen Verfahren und die Prüfabläufe benötigten Daten abrufbar gespeichert, insbesondere Daten der Struktureinheit 1 und des Halbleiterbauelements 2, Livebilder 3 und grafische Repräsentationen, Daten zur Signalsteuerung der Prüfsignale und Daten zur Positionierung und Kontaktierung und andere.

### Bezugszeichenliste

- 1: Struktureinheit, Wafer
- 2: Halbleiterbauelement
- 3: Livebild
- 4: grafische Repräsentation
- 5: Overlay
- 6: Halbleiterbauelement-Grenze
- 7: Halbleiterbauelement-Kennzeichnung
- 8: Kontaktflächen-Reihen
- 9: Kontaktfläche
- 10: Prober
- 11: Computersteuereinheit
- 12: Maschinensteuerung
- 18: Haltevorrichtung, Chuck
- 19: Haltefläche
- 20: Auflageplatte
- 23: Bewegungsvorrrichtung
- 24: Antrieb
- 25: Sondenhalterung
- 26: Sondenanordnung, Sondenspitzen
- 27: Probecard
- 28: zentrale Öffnungen
- 29: Gehäuse
- 30: Abbildungseinheit
- 31: Steuerung der Abbildungseinheit
- 32: Speichereinheit
- 33: Displayeinheit
- 34: Eingabevorrichtung

## Patentansprüche

1. Verfahren zur optischen Darstellung von elektronischen Halbleiterbauelementen (2) auf Struktureinheiten (1), folgende Schritte umfassend:
- Bereitstellung einer Struktureinheit (1), auf deren Vorderseite zumindest ein Halbleiterbauelement (2) ausgebildet ist, auf einer Haltefläche (19) einer Haltevorrichtung (18),
- Bereitstellung zumindest einer elektronisch gespeicherten grafischen Repräsentation (4), nachfolgend als grafische Repräsentation (4) bezeichnet, von einem oder mehreren Elementen aus folgender Liste: die Struktureinheit (1); ein Ausschnitt davon; das Halbleiterbauelement (2); ein Ausschnitt davon; Grenzen der Haltefläche; Referenzpunkte der Struktureinheit (1), des Halbleiterbauelements (2) oder der Haltevorrichtung (18),
- Aufnahme eines Bildes des Halbleiterbauelements (2) oder eines Ausschnitts davon mittels einer Abbildungseinheit (30) und Anzeige des Bildes auf einer ersten Displayeinheit (33) als Livebild (3),
- Anzeige einer ersten grafischen Repräsentation (4) auf der ersten Displayeinheit (33) derart, so dass Elemente der ersten grafischen Repräsentation (4) das Livebild (3) überlagern, wobei ein überlagerndes Element nachfolgend als Overlay (5) bezeichnet wird,
- computergestützte Synchronisierung zumindest der ersten grafischen Repräsentation (4) mit dem Livebild (3) derart, dass zumindest ein Overlay (5) mit dem zugehörigen Element des Livebildes (3) korrespondiert,
- wobei ein oder mehrere Overlays (5) eines Ausschnitts der Struktureinheit (1) in einem Overlaybild festgehalten und das Overlaybild in einer weiteren grafischen Repräsentation (4) für weitere gleichartige Ausschnitte der Struktureinheit (1) verwendet wird.

2. Verfahren nach Anspruch 1, wobei die Synchronisierung derart erfolgt, dass eine synchronisierte grafische Repräsentation (4) einer Verschiebung der Struktureinheit (1) relativ zur Abbildungseinheit (30) folgt.

3. Verfahren nach einem der vorstehenden Ansprüche, wobei das Livebild (3) und/oder eine weitere grafische Repräsentation (4) zumindest eine Sondenspitze (26) zur Kontaktierung des Halbleiterbauelements (2) darstellt.

4. Verfahren nach einem der vorstehenden Ansprüche, wobei eine grafische Repräsentation (4) mittels einer Eingabevorrichtung (34) durch einen Operator um ein Overlay (5) ergänzt wird, welches der Operator aus Informationen des Livebildes (3) oder einer grafischen Repräsentation (4) generiert.

5. Verfahren nach einem der vorstehenden Ansprüche, wobei zumindest eine der weiteren grafischen Repräsentationen (4) auf der ersten Displayeinheit (33) oder einer zweiten Displayeinheit angezeigt wird.

6. Verfahren zur Kontaktierung eines auf der Vorderseite einer Struktureinheit ausgebildeten Halbleiterbauelements (2) mittels Sondenspitzen, folgende Verfahrensschritte umfassend:
- optische Darstellung eines Halbleiterbauelements (2) einer Struktureinheit (1) oder eines Ausschnitts davon nach einem der vorstehenden Ansprüche,
- Anzeige der Sondenspitzen (26) in der Darstellung gemäß Anspruch 3,
- Ausrichtung der Position der Kontaktflächen des Halbleiterbauelements (2) und der Sondenspitzen (26) relativ zueinander derart, dass sich Kontaktflächen und Sondenspitzen (26) mit einem Abstand gegenüber liegen unter Beobachtung der Relativbewegung von Sondenspitzen (26) und/oder Kontaktflächen und
- Ausführung einer Zustellbewegung zwischen Halbleiterbauelement (2) und Sondenspitzen (26) bis zur Herstellung eines physischen und elektrischen Kontakts.

7. Vorrichtung zur Ausführung des Verfahrens nach Anspruch 1 zur optischen Darstellung von elektronischen Halbleiterbauelementen (2) auf Struktureinheiten (1), folgende Komponenten umfassend:
- eine Haltevorrichtung (18) mit einer Haltefläche (19) zur Aufnahme einer Struktureinheit (1),
- eine Abbildungseinheit (30) zur Beobachtung und Aufnahme von Livebildern (3) eines Halbleiterbauelements (2),
- eine Bewegungsvorrichtung (23), welche die Haltevorrichtung (18) und/oder die Abbildungseinheit (30) relativ zueinander in zumindest einer Ebene, welche parallel zur Haltefläche liegt (19), bewegt,
- eine Speichereinheit (32) zur Speicherung von Livebildern (3) und grafischen Repräsentationen (4),
- zumindest eine Displayeinheit (33) zur Darstellung der Livebilder (3) und/oder grafischen Repräsentationen (4) und
- eine Computersteuereinheit (11) zur Steuerung der Abbildungseinheit (30), der Bewegungsvorrichtung (23), der Speichereinheit (32) und der Displayeinheit(33),
- wobei die Computersteuereinheit (11) softwaremäßig ausgebildet ist zur Synchronisation zumindest einer gespeicherten grafischen Repräsentation (4) mit einem Livebild (3) derart, dass ein Element der grafischen Repräsentation (4) mit einem Element des Livebildes (3) korrespondiert und
- wobei die Computersteuereinheit (11) weiter softwaremäßig ausgebildet ist zur Erzeugung eines Overlaybild als eine weitere grafische Repräsentation (4), welche aus einem oder mehreren Overlays (5) eines Ausschnitts der Struktureinheit (1) gebildet ist.

8. Vorrichtung nach Anspruch 7, weiter umfassend eine Eingabeeinheit (34) zur Eingabe und Erzeugung von Informationen eines der Elemente aus folgender Liste betreffend: die Struktureinheit (1), das Halbleiterbauelement (2), das Livebild (3), eine grafische Repräsentation (4).

9. Vorrichtung zur Ausführung des Verfahrens nach Anspruch 6, folgende Komponenten umfassend:
- eine Vorrichtung nach einem der Ansprüche 7 oder 8,
- Sondenspitzen (26) zur physischen und elektrischen Kontaktierung des Halbleiterbauelements (2),
- wobei die Sondenspitzen (26) und/oder die Haltefläche (19) mittels der Bewegungsvorrichtung (23) relativ zueinander zur Herstellung des Kontakts zwischen Sondenspitzen (26) und Halbleiterbauelement (2) zustellbar sind.

## Claims

1. Method for optically representing electronic semiconductor components (2) on structural units (1), comprising the following steps:
- providing a structural unit (1), on the front side of which at least one semiconductor component (2) is formed, on a holding surface (19) of a holding device (18),
- providing at least one electronically stored graphical representation (4), referred to hereinafter as graphical representation (4), of one or more elements from the following list: the structural unit (1); a segment thereof; the semiconductor components (2); a segment thereof; boundaries of the holding surface; reference points of the structural unit (1), of the semiconductor component (2) or of the holding device (18),
- recording an image of the semiconductor component (2) or a segment thereof by means of an imaging unit (30) and displaying the image on a first display unit (33) as a live image (3),
- displaying a first graphical representation (4) on the first display unit (33) such that elements of the first graphical representation (4) overlay the live image (3), wherein an overlaying element is referred to hereinafter as overlay (5),
- computer-aided synchronization of at least the first graphical representation (4) with the live image (3) such that at least one overlay (5) corresponds to the associated element of the live image (3),
- wherein one or more overlays (5) of a segment of the structural unit (1) is/are captured in an overlay image and the overlay image is used in a further graphical representation (4) for further segments of the structural unit (1) that are of the same type.

2. Method according to Claim 1, wherein the synchronization is carried out such that a synchronized graphical representation (4) follows a displacement of the structural unit (1) relative to the imaging unit (30) .

3. Method according to either of the preceding claims, wherein the live image (3) and/or a further graphical representation (4) represent(s) at least one probe tip (26) for contacting the semiconductor component (2).

4. Method according to any of the preceding claims, wherein a graphical representation (4) is supplemented by an overlay (5) by an operator by means of an input device (34), said overlay being generated by the operator from information of the live image (3) or a graphical representation (4).

5. Method according to any of the preceding claims, wherein at least one of the further graphical representations (4) is displayed on the first display unit (33) or a second display unit (6).

6. Method for contacting a semiconductor component (2) formed on the front side of a structural unit by means of probe tips, comprising the following method steps:
- optically representing a semiconductor component (2) of a structural unit (1) or a segment thereof according to any of the preceding claims,
- displaying the probe tips (26) in the representation according to Claim 3,
- orienting the position of the contact pads of the semiconductor component (2) and the probe tips (26) relative to one another such that contact pads and probe tips (26) are opposite one another at a distance while observing the relative movement of probe tips (26) and/or contact pads, and
- carrying out a positional adjustment movement between semiconductor component (2) and probe tips (26) until a physical and electrical contact is established.

7. Device for carrying out the method according to Claim 1, for optically representing electronic semiconductor components (2) on structural units (1), comprising the following components:
- a holding device (18) having a holding surface (19) for receiving a structural unit (1),
- an imaging unit (30) for observing and recording live images (3) of a semiconductor component (2),
- a movement device (23), which moves the holding device (18) and/or the imaging unit (30) relative to one another in at least one plane that is parallel to the holding surface (19),
- a storage unit (32) for storing live images (3) and graphical representations (4),
- at least one display unit (33) for representing the live images (3) and/or graphical representations (4), and
- a computer control unit (11) for controlling the imaging unit (30), the movement device (23), the storage unit (32) and the display unit (33),
- wherein the computer control unit (11) is configured in terms of software for synchronizing at least one stored graphical representation (4) with a live image (3) such that an element of the graphical representation (4) corresponds to an element of the live image (3), and
- wherein the computer control unit (11) is further configured in terms of software for generating an overlay image as a further graphical representation (4) formed from one or more overlays (5) of a segment of the structural unit (1).

8. Device according to Claim 7, further comprising an input unit (34) for inputting and generating information concerning one of the elements from the following list: the structural unit (1), the semiconductor component (2), the live image (3), a graphical representation (4).

9. Device for carrying out the method according to Claim 6, comprising the following components:
- a device according to either of Claims 7 and 8,
- probe tips (26) for physically and electrically contacting the semiconductor component (2),
- wherein the probe tips (26) and/or the holding surface (19) are/is positionally adjustable relative to one another by means of the movement device (23) in order to establish the contact between probe tips (26) and semiconductor component (2).

## Revendications

1. Procédé de représentation optique de composants électroniques à semi-conducteur (2) sur des unités de structuration (1), comprenant les étapes suivantes :
- la fourniture d'une unité de structuration (1), sur la face avant de laquelle est réalisé au moins un composant à semi-conducteur (2), sur une surface de retenue (19) d'un dispositif de retenue (18),
- la fourniture d'au moins une représentation graphique (4) stockée électroniquement, ci-après appelée représentation graphique (4), d'un ou de plusieurs éléments de la liste suivante : l'unité de structuration (1) ; une partie de celle-ci ; le composant à semi-conducteur (2) ; une partie de celui-ci ; des limites de la surface de retenue ; des points de référence de l'unité de structuration (1) du composant à semi-conducteur (2) ou du dispositif de retenue (18),
- l'enregistrement d'une image du composant à semi-conducteur (2) ou d'une partie de celui-ci au moyen d'une unité de représentation (30) et l'affichage de l'image sur une première unité d'affichage (33) comme une image en direct (3),
- l'affichage d'une première représentation graphique (4) sur la première unité d'affichage (33) de telle sorte que des éléments de la première représentation graphique (4) sont superposés à l'image en direct (3), un élément de superposition étant ci-après appelé incrustation (5),
- la synchronisation assistée par ordinateur au moins de la première représentation graphique (4) avec l'image en direct (3) de telle sorte qu'au moins une incrustation (5) correspond à l'élément associé de l'image en direct (3),
- une ou plusieurs incrustations (5) d'une partie de l'unité de structuration (1) étant retenue(s) sur une image d'incrustation et l'image d'incrustation étant utilisée dans une représentation graphique (4) supplémentaire pour des parties de même type supplémentaires de l'unité de structuration (1).

2. Procédé selon la revendication 1, dans lequel la synchronisation est effectuée de telle sorte qu'une représentation graphique (4) synchronisée fait suite à un décalage de l'unité de structuration (1) par rapport à l'unité de représentation (30).

3. Procédé selon l'une quelconque des revendications précédentes, dans lequel l'image en direct (3) et/ou une représentation graphique (4) supplémentaire représente(nt) au moins une pointe de sonde (26) pour la mise en contact du composant à semi-conducteur (2).

4. Procédé selon l'une quelconque des revendications précédentes, dans lequel une représentation graphique (4) est complétée au moyen d'un dispositif de saisie (34) par un opérateur avec une incrustation (5) que l'opérateur génère à partir d'informations de l'image en direct (3) ou d'une représentation graphique (4).

5. Procédé selon l'une quelconque des revendications précédentes, dans lequel au moins l'une des représentations graphiques (4) supplémentaires est affichée sur la première unité d'affichage (33) ou sur une deuxième unité d'affichage.

6. Procédé de mise en contact d'un composant à semi-conducteur (2), réalisé sur la face avant d'une unité de structuration, au moyen de pointes de sonde, comprenant les étapes de procédé suivantes :
- la représentation optique d'un composant à semi-conducteur (2) d'une unité de structuration (1) ou d'une partie de celle-ci selon l'une quelconque des revendications précédentes,
- l'affichage des pointes de sonde (26) sur la représentation selon la revendication 3,
- l'orientation de la position des surfaces de contact du composant à semi-conducteur (2) et des pointes de sonde (26) les unes par rapport aux autres de telle sorte que les surfaces de contact et les pointes de sonde (26) sont situées à l'opposé à distance en respectant le déplacement relatif des pointes de sonde (26) et/ou des surfaces de contact, et
- l'exécution d'un mouvement d'avance entre le composant à semi-conducteur (2) et les pointes de sonde (26) jusqu'à établir un contact physique et électrique.

7. Dispositif permettant d'exécuter le procédé selon la revendication 1 pour la représentation optique de composants électroniques à semi-conducteur (2) sur des unités de structuration (1), comprenant les composants suivants :
- un dispositif de retenue (18) muni d'une surface de retenue (19) pour recevoir une unité de structuration (1),
- une unité de représentation (30) pour observer et enregistrer des images en direct (3) d'un composant à semi-conducteur (2),
- un dispositif de déplacement (23) qui déplace le dispositif de retenue (18) et/ou l'unité de représentation (30) l'un par rapport à l'autre dans au moins un plan qui est situé en parallèle à la surface de retenue (19),
- une unité de stockage (32) pour stocker des images en direct (3) et des représentations graphiques (4),
- au moins une unité d'affichage (33) pour représenter les images en direct (3) et/ou des représentations graphiques (4), et
- une unité de commande informatique (11) pour commander l'unité de représentation (30), le dispositif de déplacement (23), l'unité de stockage (32) et l'unité d'affichage (33),
- l'unité de commande informatique (11) étant réalisée sous forme de logiciel pour synchroniser au moins une représentation graphique (4) stockée avec une image en direct (3) de telle sorte qu'un élément de la représentation graphique (4) correspond à un élément de l'image en direct (3), et
- l'unité de commande informatique (11) étant en outre réalisée sous forme de logiciel pour générer une image d'incrustation comme une représentation graphique (4) supplémentaire qui est formée à partir d'une ou de plusieurs incrustations (5) d'une partie de l'unité de structuration (1).

8. Dispositif selon la revendication 7, comprenant en outre une unité de saisie (34) pour saisir ou générer des informations d'un des éléments de la liste suivante concernant : l'unité de structuration (1), le composant à semi-conducteur (2), l'image en direct (3), une représentation graphique (4).

9. Dispositif permettant d'exécuter le procédé selon la revendication 6, comprenant les composants suivants :
- un dispositif selon l'une quelconque des revendications 7 et 8,
- des pointes de sonde (26) pour une mise en contact physique et électrique du composant à semi-conducteur (2),
- les pointes de sonde (26) et/ou la surface de retenue (19) pouvant être approchées les unes des autres au moyen du dispositif de déplacement (23) pour établir le contact entre les pointes de sonde (26) et le composant à semi-conducteur (2).
